# DEMANDE DE BREVET EUROPEEN

(11) **EP 4 838 230 A1**
(43) Date de publication de la demande: **11.11.2026**
(21) Numéro de dépôt: 26176977.2
(22) Date de dépôt: 06.05.2026
(51) Int. Cl.: G01R 29/08, G01R 1/00

(54) **OUTILLAGE DE MESURE POUR ANTENNE**

(30) Priorité: 07.05.2025 FR 2504843
(71) Demandeur: Naval Group, 75015 Paris (FR)
(72) Inventeur: CARREGA, Jean-François, 83041 Toulon Cedex 9 (FR); GAMBIN, Joseph, 83041 Toulon Cedex 9 (FR); CADIERE, Thomas, 83041 Toulon Cedex 9 (FR); CAILLEAU, François, 83041 Toulon Cedex 9 (FR)
(74) Mandataire: Lavoix

(57) **Abrégé**

L'outillage de mesure (1) pour antenne comprend une coiffe (3) sensiblement cylindrique s'étendant selon un axe (H3), ayant une surface intérieure (5) et une surface extérieure (4), opposée à la surface intérieure (5), la surface intérieure (5) définissant un volume de réception (6) configuré pour recevoir une antenne ou un empilement d'antennes (2), la surface intérieure (5) étant couverte d'un revêtement absorbant d'onde électromagnétique (11), au moins une fenêtre (9) s'étendant radialement vers l'extérieur depuis la surface extérieure (4).

## Description

La présente invention concerne un outillage de mesure pour antenne.

Dans le domaine des antennes, il est connu de procéder à la calibration ou à la mesure d'antenne ou d'empilement d'antennes à l'aide d'instruments dédiés. Cette calibration demande un environnement particulier, isolé des interférences qui perturbent l'opération, comme une chambre anéchoïque. Cela nécessite que l'antenne, ou l'empilement d'antennes, soit démontée de son support et transportée dans une telle installation ce qui demande la mise en place d'une logistique lourde et qui doit être répétée pour chacune des antennes ou empilements d'antennes concernées.

C'est à ces problèmes qu'entend plus particulièrement remédier l'invention, en proposant un outillage de mesure pour antenne qui permette de faciliter et d'accélérer les opérations sur les antennes.

À cet effet, l'invention concerne un outillage de mesure pour antenne comprenant une coiffe sensiblement cylindrique s'étendant selon un axe, ayant une surface intérieure et une surface extérieure, opposée à la surface intérieure, définissant un volume de réception configuré pour recevoir une antenne ou un empilement d'antennes. La surface intérieure est couverte d'un revêtement absorbant d'onde électromagnétique et au moins une fenêtre s'étend radialement vers l'extérieur depuis la surface extérieure.

Grâce à l'invention, la mesure de l'antenne ou l'empilement d'antennes est réalisée avec un outillage coiffant l'antenne ou l'empilement d'antennes sans avoir à la ou à le démonter, ou, en atelier, sans avoir à mobiliser une pièce équipée dédiée. L'outillage permet de reproduire simplement un environnement de test proche de la situation d'exploitation.

Selon des aspects avantageux mais non obligatoires de l'invention, un tel outillage de mesure pour antenne peut comprendre une ou plusieurs des caractéristiques suivantes prises isolément ou selon toute combinaison techniquement admissible :
- le revêtement absorbant est fixé à la coiffe par un dispositif de maintien.
- le dispositif de maintien est fixé à la coiffe par des grenouillères.
- le dispositif de maintien comprend deux demi-couronnes.
- la coiffe comprend en outre une extrémité distale présentant une paroi et un trou de centrage.
- l'outillage de mesure pour antenne comprend en outre un chevalet, comprenant une tête, un pion et une pluralité de jambes, la tête étant apte à coopérer avec la

paroi de l'extrémité distale et le trou de centrage étant configuré pour coopérer avec le pion, les jambes sont agencées pour coopérer avec l'antenne.
- l'outillage de mesure pour antenne comprend exactement deux fenêtres.

L'invention porte également sur un procédé mettant en œuvre le dispositif selon l'invention comprenant les étapes suivantes :
A) Pose du chevalet sur l'antenne ou l'empilement d'antennes,
B) Pose sur le chevalet de la coiffe équipée d'au moins un instrument de mesure monté sur la fenêtre de la coiffe,
C) Mise en rotation de la coiffe selon l'axe,
D) Arrêt dans une position angulaire mettant en vis-à-vis une zone de l'antenne à configurer et l'instrument de mesure de la coiffe,
E) Mesure de l'antenne ou de l'empilement d'antennes dans la position angulaire au moyen de l'instrument de mesure,
F) Répétition des étapes C) à E) pour chaque zone de l'antenne ou l'empilement d'antennes à configurer.

Selon un aspect avantageux mais non obligatoire de l'invention, un tel procédé peut comprendre la caractéristique suivante :
- Pour un outillage comprenant deux fenêtres équipées chacune d'au moins un instrument de mesure, à l'étape E), la mesure se fait avec l'injection d'un signal identique sur les deux instruments de mesures.

L'invention sera mieux comprise, et d'autres avantages de celle-ci apparaîtront plus clairement à la lumière de la description qui va suivre, donnée uniquement à titre d'exemple et faite en référence aux dessins annexés, dans lesquels :
- la figure 1 est une vue en perspective de l'ensemble d'un outillage de mesure selon un mode de réalisation de l'invention positionné sur une antenne ;
- la figure 2 est une vue en perspective d'une coiffe de l'outillage de mesure de la figure 1 conforme à l'objet de l'invention ;
- la figure 3 est une vue de côté de la coiffe de la figure 2 selon une première orientation ;
- la figure 4 est une vue de côté de la coiffe de la figure 2 selon une deuxième orientation et
- la figure 5 est une vue de côté d'un chevalet de l'outillage de mesure de la figure 1.

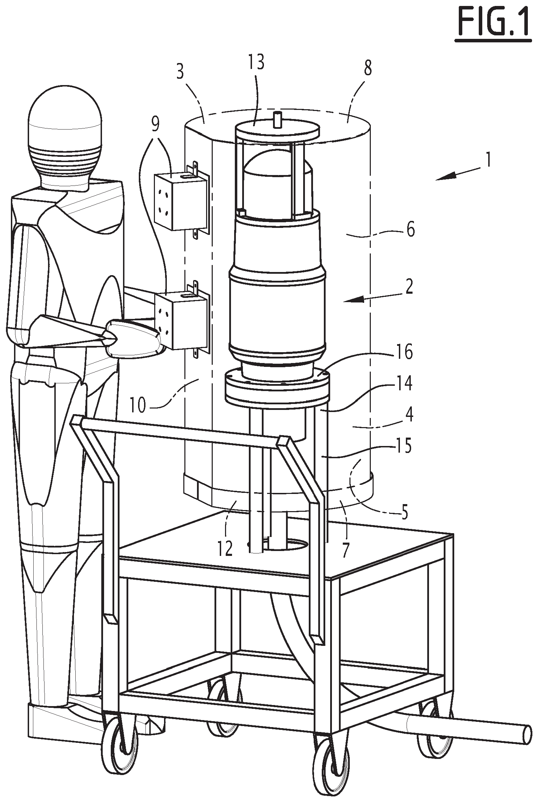

Sur la Figure 1, un outillage de mesure 1 pour antenne selon un mode de réalisation de l'invention est représenté. L'outillage 1 est installé sur une antenne ou empilement d'antennes 2 afin de mesurer ses caractéristiques.

L'antenne ou l'empilement d'antennes 2 est un dispositif connu par ailleurs et est par exemple un goniomètre ou une antenne omnidirectionnelle ou une combinaison de différents types d'antennes.

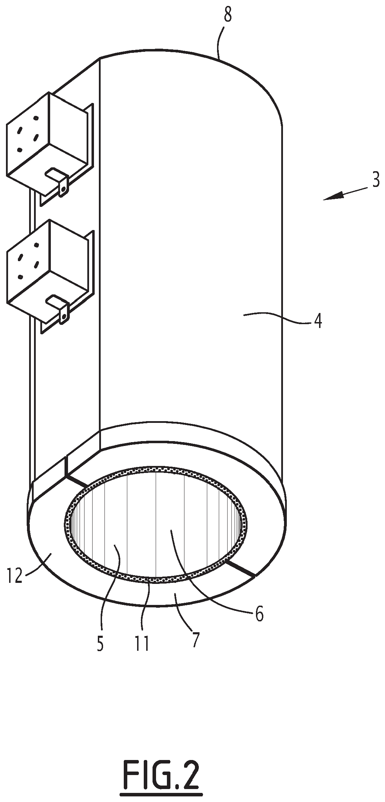

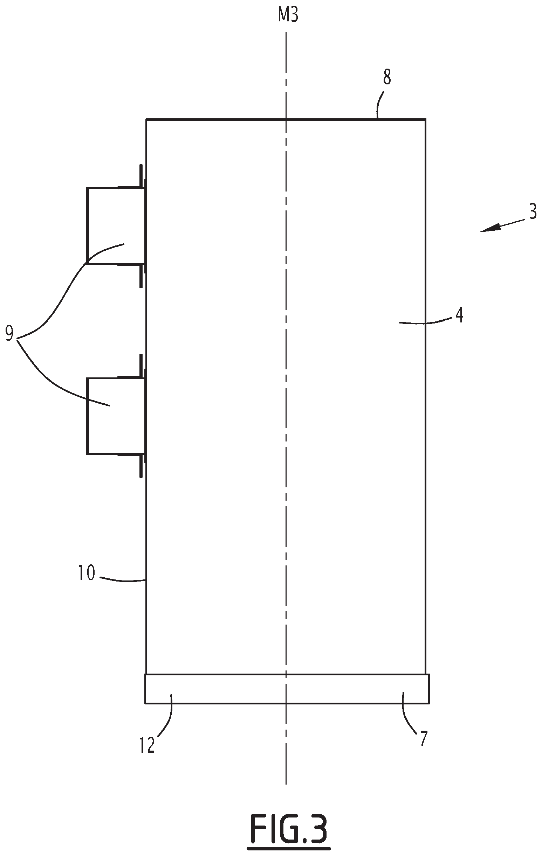

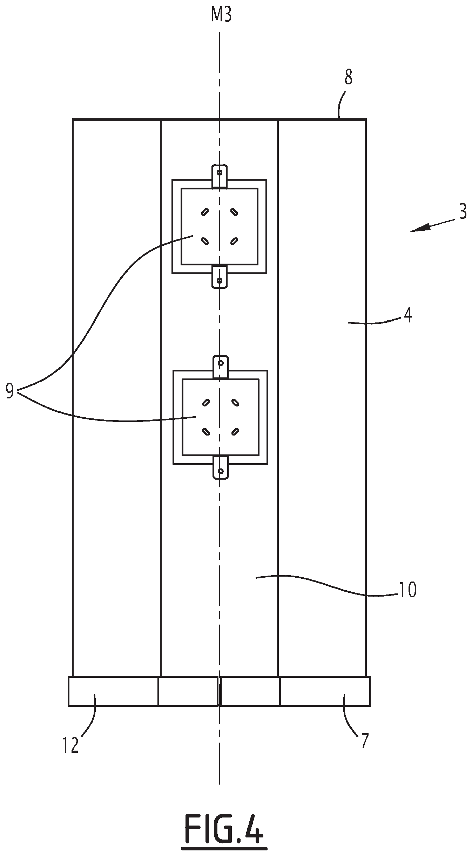

L'outillage 1 comprend une coiffe 3. Les Figures 2, 3 et 4 représentent plus en détail la coiffe 3 qui est sensiblement cylindrique et tubulaire. On définit un axe de hauteur H3 comme étant l'axe de révolution de la coiffe 3. La coiffe 3 a une surface extérieure 4 et une surface intérieure 5, opposée à la surface extérieure 4. Préférentiellement, la coiffe 3 est en aluminium.

La surface intérieure 5 définit un volume d'accueil 6. Le volume d'accueil 6 permet de recevoir l'antenne ou l'empilement d'antennes 2. De préférence, la hauteur de la coiffe 3 permet de couvrir entièrement l'antenne ou l'empilement d'antennes 2, c'est à dire que toutes les surfaces fonctionnelles de l'antenne ou de l'empilement d'antennes 2 sont contenues dans le volume d'accueil 6. Préférentiellement, la coiffe 3 a une hauteur sensiblement égale à 1,5 fois la hauteur de l'antenne ou de l'empilement d'antennes 2 testé, ce qui présente l'avantage de couvrir entièrement l'antenne ou l'empilement d'antennes 2 et d'avoir un volume d'accueil 6 libre suffisant pour assurer une désaturation satisfaisante. La coiffe 3 a une extrémité proximale 7 et une extrémité distale 8, opposées l'une à l'autre selon la direction de l'axe H3. L'extrémité proximale 7 de la coiffe 3 est libre et forme une ouverture et permettant le passage de l'antenne ou de l'empilement d'antennes 2 dans le volume d'accueil 6. L'extrémité distale 8 de la coiffe 3 comprend une paroi fermant le volume d'accueil 6.

La coiffe 3 comprend en outre au moins une ouverture formant une fenêtre 9. La fenêtre 9 s'ouvre sur la périphérie de la coiffe et s'étend radialement à partir de la surface extérieure 4 vers l'extérieur de la coiffe 3. Le fenêtre 9 est sensiblement tubulaire. La fenêtre 9 est apte à recevoir au moins un instrument de mesure (non représenté) tel qu'un ou des cornets d'émission de signaux électromagnétiques. Ces instruments de mesure sont connus par ailleurs. La fenêtre 9 présente des surfaces et des aménagements permettant la fixation des instruments de mesure. La fenêtre 9 peut, dans un mode de réalisation illustré à la Figure 2, avoir une forme prismatique pour faciliter la fixation des instruments.

Selon un mode de réalisation, la surface extérieure 4 de la coiffe 3 comprend un méplat 10. Dans ce mode de réalisation, la fenêtre 9 s'étend de la coiffe 3 à partir du méplat 10. Le méplat 10 s'étend dans un mode de réalisation sur toute la hauteur de la coiffe 3. La surface plane du méplat 10 présente l'avantage d'être une forme facilitant la fixation d'éléments telle que la fenêtre 9. La fenêtre 9 est alors soudée ou visée par l'intermédiaire de pates sur le méplat 10.

Dans un mode de réalisation préférentiel, la coiffe 3 comprend deux fenêtres 9 permettant d'utiliser deux cornets d'émission d'ondes électromagnétiques simultanément. Cela présente l'avantage d'avoir deux zones mesurées, ces zones mesurées pouvant être sur des antennes différentes dans le cas d'un empilement d'antennes 2. Les fenêtres 9 sont par exemple positionnées dans la moitié supérieure de la coiffe 3, c'est-à-dire plus proches de l'extrémité distale 8 que de l'extrémité proximale 7, pour être en face des zones fonctionnelles de l'antenne ou l'empilement d'antennes 2 testé.

La coiffe 3 est une cage de Faraday empêchant la pénétration des ondes électromagnétiques provenant de sources extérieures de l'environnement de test. La coiffe 3 a donc pour effet une désaturation de l'antenne ou l'empilement d'antennes 2 testé ce qui présente l'avantage de pouvoir réaliser l'ensemble du protocole de mesures dans un atelier sans aménagement spécifique ou même sans démonter l'antenne ou l'empilement d'antennes 2 de son support tout en garantissant que les conditions de test sont toujours les mêmes.

Selon un mode de réalisation, la coiffe 3 comprend en outre un revêtement absorbant d'ondes électromagnétiques 11 fixé sur la surface intérieure 5 par exemple par collage ou par contrainte mécanique. Le revêtement absorbant 11 est par exemple une mousse polyuréthane chargée en carbone connue par ailleurs.

Le revêtement absorbant 11 présente l'avantage de limiter la réflexion des ondes émises par les instruments de mesure et donc de maintenir un volume désaturant l'antenne ou l'empilement d'antennes 2.

Dans un mode de réalisation préférentiel, l'extrémité proximale 7 de la coiffe 3 comprend en outre un dispositif de maintien 12 du revêtement absorbant 11. Le dispositif de maintien 12 sert à contraindre mécaniquement axialement le revêtement absorbant 11 de façon à le garder positionné dans la coiffe 3. Le dispositif de maintien 12 forme par exemple une cornière ayant une première aile s'ajustant à la dimension de la surface intérieure 5 et une deuxième aile dépassant de l'extrémité proximale 7 de la coiffe 3 parallèlement à l'axe H3 et s'étendant radialement vers l'extérieur. Le dispositif de maintien 12 est fixé de façon amovible à la coiffe 3 par exemple avec des grenouillères latérales, non représentées, disposées d'une part sur la coiffe 3 et d'autre part sur le dispositif de maintien 12. Dans un autre mode de réalisation, le dispositif de maintien 12 peut être en deux parties, par exemple deux demi-couronnes, qui s'assemblent par des grenouillères de liaison non représentées disposées sur chacune des demi-couronnes. L'avantage de cet agencement est de faciliter la mise en place de chaque partie du dispositif de maintien 12 sans risque d'arcboutement.

Selon un mode de réalisation, la coiffe 3 comprend en outre un trou de centrage 13 sur la paroi de son extrémité distale 8.

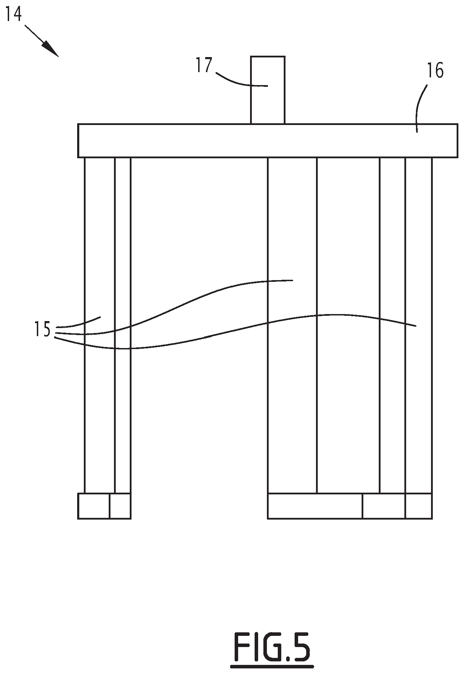

Dans un mode de réalisation, afin de positionner la coiffe 3 sur l'antenne ou l'empilement d'antennes 2, un chevalet d'interface 14 est utilisé. Le chevalet 14 comprend des jambes 15 s'étendant à partir d'une tête 16. La tête 16 est par exemple un disque. La tête 16 comprend en outre un pion 17. Le pion 17 du chevalet 14 est apte à coopérer avec le trou de centrage 13 de la coiffe 3 permettant ainsi d'empêcher les mouvements la coiffe 3 dans toutes les directions perpendiculaires à l'axe H3. Dans un mode de réalisation, le revêtement absorbant 11 ne recouvre pas la totalité de la paroi de l'extrémité distale 8 de la coiffe 3, cette paroi de l'extrémité distale 8 définissant ainsi une forme apte à coopérer avec le disque 12 du chevalet 14. Le chevalet 14 comprend en outre des jambes 15. Dans le mode de réalisation de la Figure 5 le chevalet 14 compte trois jambes disposées régulièrement, à 120° l'une de l'autre. L'épaisseur des jambes 15 est le compromis de résistance mécanique au poids de la coiffe 3 et la minimisation de la couverture des surfaces actives de l'antenne ou l'empilement d'antennes 2. Les jambes 15 comprennent également des pieds. Les pieds sont en contact avec l'antenne ou l'empilement d'antennes 2 et sont aptes à être fixés de façon amovible à l'antenne ou l'empilement d'antennes 2. Par exemple, les pieds présentent des perçages et sont visés à l'antenne ou l'empilement d'antennes 2. Les pieds peuvent avoir une largeur supérieure à celle des jambe 15 pour assurer un bon contact avec l'antenne ou l'empilement d'antennes 2. Le chevalet est par exemple en polycarbonate.

Un exemple de procédé de fonctionnement de l'outillage de mesure 1 décrit ci-dessus va à présent être décrit.
- Le chevalet 14 est posé puis fixé de façon réversible sur l'antenne ou l'empilement d'antennes 2,
- La coiffe 3 est posée sur le chevalet 14,
- Les instruments de mesure sont fixés sur la ou les fenêtres 9,
- La coiffe 3 est mise en rotation selon l'axe H3 puis arrêtée pour la mesure afin que les fenêtres 9 et donc les instruments de mesure atteignent la position angulaire les mettant en vis-à-vis de chacune des zones à configurer tout autour de l'antenne ou l'empilement d'antennes 2, tout en bénéficiant en continue de la désaturation fournie par la coiffe 3.
- La mesure est réalisée par les instruments à chacune des positions angulaires d'intérêt.

Dans un mode de réalisation particulier du procédé, les signaux émis par les instruments lors de la mesure sont identiques. Cela présente l'avantage de pouvoir tester simultanément et indépendamment des antennes différentes avec le même signal et cela sans interférence.

Les modes de réalisation et les variantes mentionnées ci-dessus peuvent être combinés entre eux pour générer de nouveaux modes de réalisation de l'invention.

## Revendications

1. Outillage de mesure (1) pour antenne comprenant une coiffe (3) sensiblement cylindrique s'étendant selon un axe (H3), ayant une surface intérieure (5) et une surface extérieure (4), opposée à la surface intérieure (5), la surface intérieure (5) définissant un volume de réception (6) configuré pour recevoir une antenne ou un empilement d'antennes (2), la surface intérieure (5) étant couverte d'un revêtement absorbant d'onde électromagnétique (11), et au moins une fenêtre (9) apte à recevoir au moins un instrument de mesure, **caractérisé en ce que en ce que** la surface extérieure (4) comprend un méplat (10) et **en ce que** l'au moins une fenêtre (9) s'étend radialement vers l'extérieur depuis la surface extérieure (4) de la coiffe (3), à partir du méplat (10).

2. Outillage de mesure (1) pour antenne selon la revendication 1, dans lequel le revêtement absorbant (11) est fixé à la coiffe (3) par un dispositif de maintien (12).

3. Outillage de mesure (1) pour antenne selon la revendication 2, dans lequel le dispositif de maintien (12) est fixé à la coiffe (3) par des grenouillères.

4. Outillage de mesure (1) pour antenne selon la revendication 2 ou 3 dans lequel le dispositif de maintien (12) comprend deux demi-couronnes.

5. Outillage de mesure (1) pour antenne selon l'une quelconque des revendications 1 à 4, dans lequel la coiffe (3) comprend en outre une extrémité distale (8) présentant une paroi et un trou de centrage (13).

6. Outillage de mesure (1) pour antenne selon la revendication 5, comprenant en outre un chevalet (14), comprenant une tête (12), un pion (17) et une pluralité de jambes (15), la tête (12) étant apte à coopérer avec la paroi de l'extrémité distale (8) et le trou de centrage (13) étant configuré pour coopérer avec le pion (17), les jambes (15) étant agencées pour coopérer avec l'antenne ou l'empilement d'antennes (2).

7. Outillage de mesure (1) pour antenne selon l'une quelconque des revendications 1 à 6, comprenant exactement deux fenêtres (9).

8. Procédé de fonctionnement de l'outillage de mesure (1) pour antenne selon la revendication 6 ou 7, comprenant les étapes suivantes :
- A) Pose du chevalet (14) sur une antenne ou un empilement d'antennes (2),
- B) Pose sur le chevalet (14) de la coiffe (3) équipée d'au moins un instrument de mesure sur la fenêtre (9) de la coiffe (3),
- C) Mise en rotation de la coiffe (3) selon l'axe (H3),
- D) Arrêt dans une position angulaire mettant en vis-à-vis une zone de l'antenne ou l'empilement d'antennes (2) à configurer et l'instrument de mesure de la coiffe (3),
- E) Mesure de l'antenne ou de l'empilement d'antennes (2) dans la position angulaire au moyen de l'instrument de mesure,
- F) répétition des étapes C) à E) pour chaque zone de de l'antenne ou l'empilement d'antennes (2) à configurer.

9. Procédé de fonctionnement de l'outillage de mesure (1) selon la revendication 8, dans lequel la coiffe (3) comprend deux fenêtres équipées chacune d'au moins un instrument de mesure, le procédé de fonctionnement comprenant en outre à l'étape E) une injection d'un signal identique sur les deux instruments de mesures.
